# EUROPEAN PATENT APPLICATION

(11) **EP 4 819 440 A1**
(43) Date of publication of application: **07.10.2026**
(21) Application number: 26167941.9
(22) Date of filing: 26.03.2026
(51) Int. Cl.: H02J 7/84, H02J 7/50, H01M 10/48, H02J 7/96, H02J 7/82

(54) **BATTERY PACK FOR JOB-SITE ELECTRICAL EQUIPMENT, AND METHOD FOR DIAGNOSING BATTERY PACK FOR JOB-SITE ELECTRICAL EQUIPMENT**

(30) Priority: 31.03.2025 JP 2025059033
(71) Applicant: Makita Corporation, Anjo-shi Aichi 446-8502 (JP)
(72) Inventor: UMEMURA, Takuya, 446-8502 Anjo-shi, Aichi (JP); KOBAE, Shoma, 446-8502 Anjo-shi, Aichi (JP)
(74) Representative: Kramer Barske Schmidtchen Patentanwälte PartG mbB

(57) **Abstract**

One aspect of the present disclosure provides a battery pack (1) including a first positive-electrode terminal (11), a first negative-electrode terminal (12), first through nth battery modules (25a1-25an), and a control circuit (18), where n is any natural number greater than or equal to two. The control circuit is configured to detect a malfunction in at least any one of the first through nth battery modules based on respective full charge capacities of the first through nth battery modules.

## Description

### BACKGROUND

The present disclosure relates to a battery pack for job-site electrical equipment.

Japanese Patent No. 7313242 discloses a battery pack including two or more battery cells coupled in series. The battery pack is configured to output a charge inhibition signal to a charger in response to a voltage imbalance among the battery cells.

### SUMMARY

Recent battery packs used in electric power tools generally include two or more battery modules coupled in series, where each battery module includes two or more battery cells coupled in parallel. As the number of battery cells coupled in parallel increases, a voltage drop of a corresponding battery module upon occurrence of a malfunction in one of the battery cells may become smaller. Accordingly, it may be difficult to detect, with high accuracy, an occurrence of a malfunction in any of the battery modules based on their respective voltages.

It is desirable that one aspect of the present disclosure can provide a technique capable of detecting, with high accuracy, an occurrence of a malfunction in at least one of battery modules coupled in series.

In the present disclosure, terms such as "first," "second," and the like are intended only to distinguish one element from another and are not intended to limit the order or the number of elements. Accordingly, a first element may be referred to as a second element, and similarly, a second element may be referred to as a first element. Additionally, a first element may be provided without a second element, and similarly, a second element may be provided without a first element.

One aspect of the present disclosure provides a battery pack for job-site electrical equipment. The battery pack includes a first positive-electrode terminal, a first negative-electrode terminal, first through nth battery modules (where n is any natural number greater than or equal to two), and a control circuit.

The first positive-electrode terminal and the first negative-electrode terminal are configured to receive charge power from a charger.

The first through nth battery modules are coupled in series in order. The first through nth battery modules are configured to be charged by the charge power.

Each of the first through nth battery modules includes two or more rechargeable battery cells. The two or more rechargeable battery cells are coupled in parallel with each other.

The first battery module includes a second positive-electrode terminal. The second positive-electrode terminal is coupled to the first positive-electrode terminal. The nth battery module includes a second negative-electrode terminal. The second negative-electrode terminal is coupled to the first negative-electrode terminal.

The control circuit is configured to derive respective full charge capacities of the first through nth battery modules based on measured values associated with respective states of charge of the first through nth battery modules.

The control circuit is configured to detect a malfunction in at least any one of the first through nth battery modules based on the respective full charge capacities derived.

The full charge capacity of each battery module decreases when at least any one of the two or more rechargeable battery cells malfunctions.

Therefore, the battery pack configured as above can detect, with high accuracy, that at least any one of the first through nth battery modules is malfunctioning based on the respective full charge capacities.

Another aspect of the present disclosure is a method for diagnosing a battery pack for job-site electrical equipment. The method includes:
deriving respective full charge capacities of two or more battery modules of the battery pack based on respective states of charge of the two or more battery modules, the two or more battery modules being coupled in series, each of the two or more battery modules including two or more rechargeable battery cells coupled in parallel; and
detecting a malfunction in at least any one of the two or more battery modules based on the respective full charge capacities derived.

With the method as above, it is possible to detect, with high accuracy, that at least any one of the first through nth battery modules is malfunctioning.

### BRIEF DESCRIPTION OF THE DRAWINGS

Example embodiments of the present disclosure will be described hereinafter with reference to the accompanying drawings, in which:
FIG. 1A is a block diagram schematically showing a circuit configuration of a battery pack in a first embodiment, and FIG. 1B is a schematic circuit diagram of a battery module in the first embodiment;
FIG. 2 is a block diagram schematically showing a circuit configuration of a charger in the first embodiment;
FIG. 3 is a flowchart of a state of charge detection process in the first embodiment;
FIG. 4 is a flowchart of a diagnostic process in the first embodiment;
FIG. 5 is an explanatory diagram showing a relationship between a state of charge of the battery module and an open circuit voltage;
FIG. 6 is an explanatory diagram schematically showing effects of the first embodiment; and
FIG. 7 is a flowchart of the diagnostic process in a third embodiment.

### DETAILED DESCRIPTION OF EXEMPLARY EMBODIMENTS

### 1. Overview of Embodiments

One embodiment may include at least any one of:
- Feature 1: a battery pack for job-site electrical equipment (or outdoor power equipment (OPE));
- Feature 2: the battery pack includes a first positive-electrode terminal and a first negative-electrode terminal configured to receive charge power from a charger;
- Feature 3: the battery pack includes first through nth battery modules (where n is any natural number or any integer that is greater than or equal to two) coupled in series in order;
- Feature 4: the first through nth battery modules are configured to be charged by the charge power;
- Feature 5: each of the first through nth battery modules includes two or more rechargeable battery cells coupled in parallel;
- Feature 6: the first battery module includes a second positive-electrode terminal coupled to the first positive-electrode terminal;
- Feature 7: the nth battery module includes a second negative-electrode terminal coupled to the first negative-electrode terminal;
- Feature 8: the battery pack includes a control circuit;
- Feature 9: the control circuit is configured (or programmed) to derive respective full charge capacities of the first through nth battery modules based on measured values associated with respective states of charge of the first through nth battery modules; and
- Feature 10: the control circuit is configured (or programmed) to detect a malfunction in at least any one of the first through nth battery modules based on the respective full charge capacities.

One embodiment including at least Features 1 through 10 can detect, with high accuracy, that at least any one of the first through nth battery modules is malfunctioning based on the respective full charge capacities.

One embodiment may include, in addition to or in place of at least any one of Features 1 through 10, at least any one of:
- Feature 11: the battery pack includes a measurement circuit configured (or programmed) to measure respective voltage values of the first through nth battery modules;
- Feature 12: the measurement circuit is configured (or programmed) to transmit the respective voltage values; and
- Feature 13: the control circuit is configured (or programmed) to receive the respective voltage values from the measurement circuit as part of the measured values.

One embodiment including at least Features 1 through 13 can derive the respective full charge capacities of the first through nth battery modules based on the respective voltage values of the first through nth battery modules measured in the battery pack.

One embodiment may include, in addition to or in place of at least any one of Features 1 through 13, at least any one of:
- Feature 14: the measurement circuit is configured (or programmed) to measure an electric current value corresponding to a magnitude of a charge current supplied from the charger to the battery pack;
- Feature 15: the measurement circuit is configured (or programmed) to transmit the electric current value; and
- Feature 16: the control circuit is configured (or programmed) to receive the electric current value from the measurement circuit as part of the measured values.

One embodiment including at least Features 1 through 16 can derive the respective full charge capacities of the first through nth battery modules based on the respective voltage values of the first through nth battery modules and the electric current value measured in the battery pack.

One embodiment may include, in addition to or in place of at least any one of Features 1 through 16, at least any one of:
- Feature 17: the charger is configured to transmit an electric current value corresponding to a magnitude of a charge current;
- Feature 18: the magnitude of the charge current is a magnitude of a charge current supplied from the charger to the battery pack; and
- Feature 19: the control circuit is configured (or programmed) to receive the electric current value from the charger as part of the measured values.

One embodiment including at least Features 1 through 13 and 17 through 19 can derive the respective full charge capacities of the first through nth battery modules based on the respective voltage values of the first through nth battery modules and the electric current value received from the charger.

One embodiment may include, in addition to or in place of at least any one of Features 1 through 19, at least any one of:
- Feature 20: the control circuit is configured (or programmed) to derive an accumulated value of the electric current value from a start of charging to an end of charging of the battery pack;
- Feature 21: the control circuit is configured (or programmed) to derive respective pre-charge states of charge and respective post-charge states of charge of the first through nth battery modules based on respective pre-charge voltage values and respective post-charge voltage values of the first through nth battery modules;
- Feature 22: the control circuit is configured (or programmed) to derive the respective full charge capacities based on the accumulated value, the respective pre-charge states of charge, and the respective post-charge states of charge;
- Feature 23: the respective pre-charge voltage values correspond to the respective voltage values of the first through nth battery modules before the start of charging;
- Feature 24: the respective post-charge voltage values correspond to the respective voltage values of the first through nth battery modules after the end of charging;
- Feature 25: the respective pre-charge states of charge correspond to respective states of charge (or respective charge levels) of the first through nth battery modules before the start of charging; and
- Feature 26: the respective post-charge states of charge correspond to respective states of charge (or respective charge levels) of the first through nth battery modules after the end of charging.

One embodiment including (i) at least Features 1 through 16 and 20 through 26 or (ii) at least Features 1 through 13 and 17 through 26 can derive the respective full charge capacities based on the accumulated value, the respective pre-charge states of charge, and the respective post-charge states of charge.

One embodiment may include, in addition to or in place of at least any one of Features 1 through 26, at least any one of:
- Feature 27: the respective pre-charge voltage values correspond to respective open circuit voltages of the first through nth battery modules before the start of charging; and
- Feature 28: the respective post-charge voltage values correspond to respective open circuit voltages of the first through nth battery modules after the end of charging.

One embodiment including (i) at least Features 1 through 16 and 20 through 28 or (ii) at least Features 1 through 13 and 17 through 28 can derive, with high accuracy, the respective pre-charge states of charge and the respective post-charge states of charge based on the respective open circuit voltage values before the start of charging and the respective open circuit voltage values after the end of charging. As a result, the respective full charge capacities can be derived with high accuracy.

One embodiment may include, in addition to or in place of at least any one of Features 1 through 28, at least any one of:
- Feature 29: the respective pre-charge voltage values correspond to respective stabilized open circuit voltages of the first through nth battery modules before the start of charging; and
- Feature 30: the respective post-charge voltage values correspond to respective stabilized open circuit voltages of the first through nth battery modules after the end of charging.

One embodiment including (i) at least Features 1 through 16, 20 through 26, 29, and 30 or (ii) at least Features 1 through 13 and 17 through 30 can derive, with higher accuracy, the respective pre-charge states of charge and the respective post-charge states of charge based on the respective stabilized open circuit voltages before the start of charging and the respective stabilized open circuit voltages after the end of charging. As a result, the respective full charge capacities can be derived with higher accuracy.

One embodiment may include, in addition to or in place of at least any one of Features 1 through 30,
- Feature 31: the control circuit is configured (or programmed) to detect the malfunction based on (i) a difference value between a largest full charge capacity and a smallest full charge capacity among the respective full charge capacities, and (ii) a preset first threshold.

One embodiment including at least Features 1 through 10 and 31 can detect the malfunction based on the difference value between the largest full charge capacity and the smallest full charge capacity.

One embodiment may include, in addition to or in place of at least any one of Features 1 through 31,
- Feature 32: the control circuit is configured (or programmed) to detect the malfunction based on (i) a ratio of a smallest full charge capacity to a largest full charge capacity among the respective full charge capacities, and (ii) a preset second threshold.

One embodiment including at least Features 1 through 10 and 32 can detect the malfunction based on the ratio of the smallest full charge capacity to the largest full charge capacity.

One embodiment may include, in addition to or in place of at least any one of Features 1 through 32,
- Feature 33: the malfunction includes at least one rechargeable battery cells being electrically uncoupled from remaining rechargeable battery cells among the two or more rechargeable battery cells in at least any one of the first through nth battery modules.

One embodiment including at least Features 1 through 10 and 33 can detect the malfunction where at least one rechargeable battery cell is electrically uncoupled from remaining rechargeable battery cells.

One embodiment may include, in addition to or in place of at least any one of Features 1 through 33,
- Feature 34: each of the first through nth battery modules has an identical rated capacity or an identical nominal capacity.

One embodiment may include, in addition to or in place of at least any one of Features 1 through 34,
- Feature 35: the control circuit is configured (or programmed), in response to detection of the malfunction in at least any one of the first through nth battery modules, (i) to transmit a prohibition signal for prohibiting charging and discharging of the battery pack and/or (ii) to store data identifying a malfunctioning battery module.

One embodiment including at least Features 1 through 10 and 35 can address malfunctions occurring in any of the first through nth battery modules.

In one embodiment, the control circuit may be integrated into a single electronic unit, a single electronic device, or a single circuit board.

In one embodiment, the control circuit may be a combination of two or more electronic circuits, two or more electronic units, or two or more electronic devices provided separately in the battery pack.

In one embodiment, the control circuit may include a microcomputer (or a microcontroller or a microprocessor), a wired logic, a graphics processing unit (GPU), an application-specific integrated circuit (ASIC), an application-specific standard product (ASSP), a programmable logic device (PLD) (e.g., a fieldprogrammable gate array (FPGA)), a discrete electronic component, and/or a combination thereof.

In one embodiment, the measurement circuit may be an analog front end (AFE), a battery management unit (BMU), a battery management system (BMS), a battery protection circuit, a PLD, a microcomputer, or any combination thereof.

One embodiment may include at least any one of:
- Feature 36: a method for diagnosing a battery pack for job-site electrical equipment;
- Feature 37: the method includes deriving respective full charge capacities of two or more battery modules of the battery pack based on respective states of charge of the two or more battery modules;
- Feature 38: the two or more battery modules are coupled in series;
- Feature 39: each of the two or more battery modules includes two or more rechargeable battery cells coupled in parallel; and
- Feature 40: the method includes detecting a malfunction in at least any one of the two or more battery modules based on the respective full charge capacities derived.

One embodiment including at least Features 36 through 40 can detect, with high accuracy, that a malfunction is occurring or has occurred in at least any one of the first through nth battery modules.

Examples of the job-site electrical equipment include various electric equipment used in job sites, such as do-it-yourself carpentry, manufacturing, gardening, and construction, and configured to be driven by a battery pack. Specifically, examples of the job-site electrical equipment include an electric power tool for masonry work, metalworking, or woodworking, a work machine for gardening, and a device for preparing an environment of a job site. More specifically, examples of the job-site electrical equipment include, but are not limited to, an electric blower, an electric hammer, an electric hammer drill, an electric drill, an electric driver, an electric wrench, an electric grinder, an electric circular saw, an electric reciprocating saw, an electric jigsaw, an electric cutter, an electric chainsaw, an electric planer, an electric nail gun (including a tacker), an electric hedge trimmer, an electric lawn mower, an electric lawn trimmer, an electric bush cutter, an electric cleaner, an electric sprayer, an electric spreader, an electric dust extractor (or an electric dust extractor), a laser distance meter (or a laser distance measuring instrument), a laser level, an optical receiver of a laser level, a wall scanner, a radio, a television, a speaker, an electric cold/warm storage, an electric kettle, a coffee machine (or a coffee maker or a coffee distillation device), a microwave oven, a robotic vacuum (or a robot vacuum), a battery-powered wheel barrow, a battery-powered bicycle, a fan vest, and a heating jacket.

In one embodiment, Features 1 through 40 may be combined in any combination.

In one embodiment, any of Features 1 through 40 may be excluded.

### 2. Specific Example Embodiments

Some specific example embodiments are described below. These specific example embodiments illustrate a battery pack 1 described below.

### 2-1. First Embodiment

### 2-1-1. Circuit Configuration of Battery Pack

The battery pack 1 is configured to be detachably attached to any compatible job-site electrical equipment (not shown) and to supply DC power to the job-site electrical equipment.

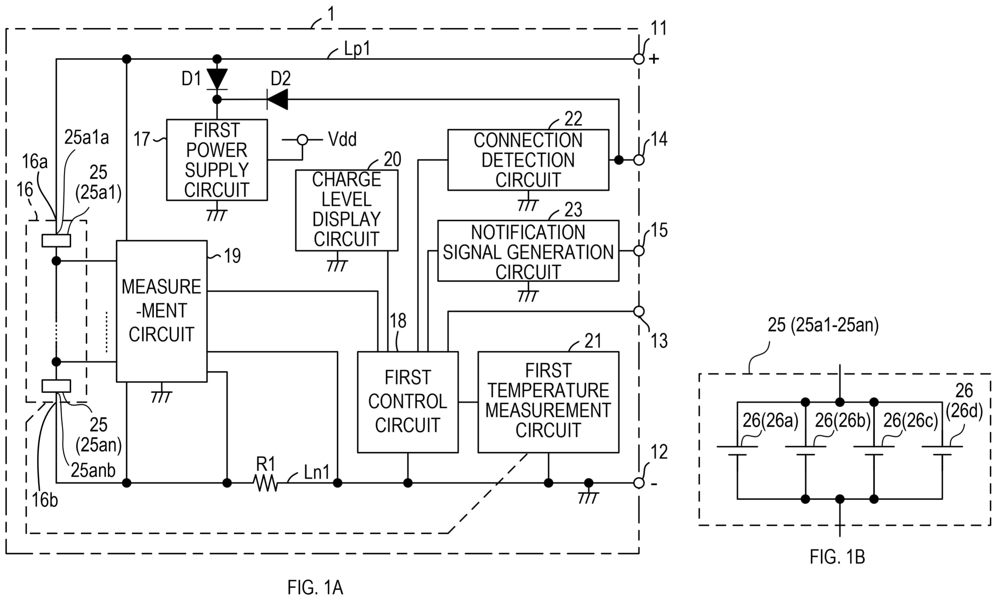

Specifically, as shown in FIG. 1A, the battery pack 1 includes a first positive-electrode terminal 11, a first negative-electrode terminal 12, a first data communication terminal 13, a Vcc input terminal 14, a notification signal output terminal 15, a first high-side current path Lp1, a first low-side current path Ln1, a first diode D1, a second diode D2, a shunt resistor R1, an assembled battery 16, a first power supply circuit 17, a first control circuit 18, a measurement circuit 19, a charge level display circuit 20, a first temperature measurement circuit 21, a connection detection circuit 22, and a notification signal generation circuit 23.

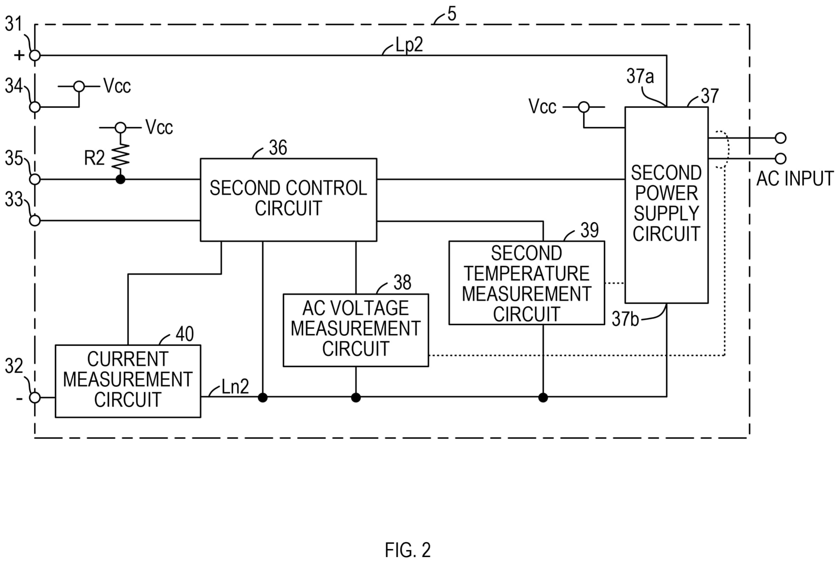

The first positive-electrode terminal 11 and the first negative-electrode terminal 12 are configured to receive charge power from a charger 5, which is described later, and shown in FIG. 2. The first positive-electrode terminal 11 is coupled to the first high-side current path Lp1 extending from the first positive-electrode terminal 11 to a positive electrode 16a of the assembled battery 16, and is thus electrically coupled to the positive electrode 16a of the assembled battery 16. Furthermore, the first positive-electrode terminal 11 is coupled to an anode of the first diode D1 via the first high-side current path Lp1.

The first negative-electrode terminal 12 is coupled to the first low-side current path Ln1 extending from the first negative-electrode terminal 12 to a negative electrode 16b of the assembled battery 16, and is thus electrically coupled to the negative electrode 16b of the assembled battery 16.

The first high-side current path Lp1 and the first low-side current path Ln1 each conduct (i) a charge current Ichg supplied to the assembled battery 16 from the charger 5 connected to the battery pack 1, and (ii) a discharge current Idis supplied from the assembled battery 16 to the job-site electrical equipment connected to the battery pack 1. The first low-side current path Ln1 is coupled to a ground of the battery pack 1. The ground is also coupled to the first power supply circuit 17, the first control circuit 18, the measurement circuit 19, the charge level display circuit 20, the first temperature measurement circuit 21, the connection detection circuit 22, and the notification signal generation circuit 23, and serves as a reference potential (or a reference voltage) for these circuits.

The shunt resistor R1 is disposed in the first low-side current path Ln1 such that both the charge current Ichg and the discharge current Idis pass through the shunt resistor R1. In another embodiment, the shunt resistor R1 may be excluded from the battery pack 1. Such a circuit configuration, although less preferred, is encompassed within the scope of the present disclosure.

The first data communication terminal 13 is coupled to the first control circuit 18. The first data communication terminal 13 is a terminal for serial communication between the first control circuit 18 and either the charger 5 or the job-site electrical equipment that is connected to the battery pack 1.

The Vcc input terminal 14 is coupled to (i) an anode of the second diode D2 and (ii) the connection detection circuit 22.

The notification signal output terminal 15 is coupled to the notification signal generation circuit 23.

The assembled battery 16 includes first through nth battery modules 25a1 through 25an (where n is any natural number greater than or equal to two) coupled in series in order between the positive electrode 16a and the negative electrode 16b.

The first through nth battery modules 25a1 through 25an are configured to be charged by the charge power supplied from the charger 5. The first battery module 25a1 includes a second positive-electrode terminal 25a1a electrically coupled to the first positive-electrode terminal 11 via the positive electrode 16a. The nth battery module 25an includes a second negative-electrode terminal 25anb electrically coupled to the first negative-electrode terminal 12 via the negative electrode 16b. Each of the first through nth battery modules 25a1 through 25an has an identical rated capacity or an identical nominal capacity.

As shown in FIG. 1B, each of the first through nth battery modules 25a1 through 25an includes first through fourth rechargeable battery cells (hereinafter simply referred to as cells) 26a through 26d coupled in parallel with each other by spot welding (or any other suitable connection method, such as laser welding or ultrasonic welding). Each of the first through fourth cells 26a through 26d has an identical rated capacity or an identical nominal capacity. The first through fourth cells 26a through 26d are lithium-ion batteries, but are not limited thereto. In another embodiment, in each of the first through nth battery modules 25al through 25an, one or two of the first through fourth cells 26a through 26d may be removed, or at least one additional cell may be coupled in parallel.

The first power supply circuit 17 is a DC-to-DC converter coupled to a cathode of the first diode D1 and a cathode of the second diode D2 and configured to generate a first power supply voltage Vdd. The cathode of the first diode D1 is coupled to the cathode of the second diode D2. Accordingly, the first power supply circuit 17 is configured to generate the first power supply voltage Vdd based on the higher of (i) a voltage between the positive-electrode 16a and the negative-electrode 16b of the assembled battery 16 (hereinafter referred to as the battery voltage Vbat) and (ii) a second power supply voltage Vcc supplied to the Vcc input terminal 14. The first power supply voltage Vdd is supplied to the first control circuit 18, the measurement circuit 19, the charge level display circuit 20, the first temperature measurement circuit 21, and the connection detection circuit 22 to operate these circuits. The battery voltage Vbat is 18 volts DC, but is not limited thereto. In another embodiment, the battery voltage Vbat may be 40 volts DC, 14.4 volts DC, or 10.8 volts DC. The first power supply voltage Vdd and the second power supply voltage Vcc are each 5 volts DC, but are not limited thereto.

The first control circuit 18 is configured to transmit and receive various signals between the first control circuit 18 and other various circuits to control charging and discharging of the assembled battery 16. More specifically, the first control circuit 18 is a microcomputer including a central processing unit (CPU), a memory, input/output (I/O) ports, a serial communication interface (SCI), a digital-to-analog converter (DAC), and an analog-to-digital converter (ADC), but is not limited to such a microcomputer. In another embodiment, the first control circuit 18 may include an additional microcomputer. In yet another embodiment, the first control circuit 18 may include, in addition to or in place of the microcomputer, a logic circuit (or wired logic connection) including two or more electronic components. In yet another embodiment, the first control circuit 18 may include, in addition to or in place of the microcomputer, a GPU, an ASIC, an ASSP, and/or a PLD.

The measurement circuit 19 is configured to measure (i) the battery voltage Vbat, (ii) all individual voltages of the first through nth battery modules 25a1 through 25an (hereinafter referred to as the first through nth module voltages Vmj1 through Vmjn), and (iii) a voltage across the shunt resistor R1 (i.e., a magnitude of the charge current Ichg or the discharge current Idis). The measurement circuit 19 is also configured to transmit a series of measured values indicating (i) the battery voltage Vbat, (ii) the first through nth module voltages Vmj1 through Vmjn, and (iii) the voltage across the shunt resistor R1, to the first control circuit 18 via serial communication with the first control circuit 18. Furthermore, the measurement circuit 19 is configured to balance the first through nth module voltages Vmj1 through Vmjn.

Specifically, the measurement circuit 19 is an AFE, but is not limited thereto. In another embodiment, the measurement circuit 19 may be a BMU, a BMS, a battery protection circuit, a PLD, a microcomputer, or any combination thereof.

The first control circuit 18 is configured (or programmed) to read, based on the series of measured values received, (i) the battery voltage Vbat, (ii) the first through nth module voltages Vmj1 through Vmjn, and (iii) the voltage across the shunt resistor R1. In another embodiment, the first control circuit 18 may be integrated with the measurement circuit 19.

The charge level display circuit 20 is configured to receive a display control signal from the first control circuit 18 and to display a charge level of the battery pack 1 (more specifically, the assembled battery 16) via a light source (e.g., a light-emitting diode (LED)), a seven-segment display, and/or a liquid crystal display (LCD), in accordance with the received display control signal. The display control signal specifies a display pattern corresponding to the battery voltage Vbat read by the first control circuit 18. In another embodiment, the charge level display circuit 20 may be excluded from the battery pack 1.

The first temperature measurement circuit 21 is configured to measure a temperature (hereinafter referred to as battery temperature Tbat) of the assembled battery 16 (or at least one of the first through nth battery modules 25al through 25an) using a not-shown temperature sensing element (e.g., a thermistor), and to transmit a first temperature measurement signal to the first control circuit 18. The first temperature measurement signal is an analog signal having a variable voltage corresponding to the battery temperature Tbat. The first control circuit 18 is configured (or programmed) to read the battery temperature Tbat based on the voltage of the first temperature measurement signal. In another embodiment, the first temperature measurement circuit 21 may be excluded from the battery pack 1. Such a circuit configuration, although less preferred, is encompassed within the scope of the present disclosure.

The connection detection circuit 22 is configured to detect whether the second power supply voltage Vcc is supplied to the Vcc input terminal 14 and to transmit a connection detection signal to the first control circuit 18. The connection detection signal is a digital signal, more specifically, a negative logic signal (or an active-low signal). The connection detection circuit 22 is configured (i) to assert the connection detection signal in response to the second power supply voltage Vcc being supplied to the Vcc input terminal 14, and (ii) negate the connection detection signal in response to the second power supply voltage Vcc not being supplied to the Vcc input terminal 14. The first control circuit 18 is configured (or programmed) (i) to detect that the battery pack 1 is connected to the charger 5 in response to receiving the asserted connection detection signal, and (ii) to detect that the battery pack 1 is not connected to the charger 5 in response to receiving the negated connection detection signal. In another embodiment, the connection detection signal may be a positive logic signal (or an active-high signal).

The notification signal generation circuit 23 is configured to receive a current control signal from the first control circuit 18 and to generate a notification signal corresponding to the received current control signal. The first control circuit 18 is configured (or programmed) to change the current control signal in accordance with a requested value of the charge current Ichg or the discharge current Idis. Specifically, the current control signal is a pulse width modulated (PWM) signal, but is not limited thereto. The notification signal may be an analog signal, a digital signal having positive logic or negative logic, or a pulse train signal.

### 2-1-2. Circuit Configuration of Charger

As shown in FIG. 2, the charger 5 includes a second positive-electrode terminal 31, a second negative-electrode terminal 32, a second data communication terminal 33, a Vcc output terminal 34, a signal input terminal 35, a second high-side current path Lp2, a second low-side current path Ln2, a pull-up resistor R2, a second control circuit 36, a second power supply circuit 37, an AC voltage measurement circuit 38, a second temperature measurement circuit 39, and a current measurement circuit 40.

The second positive-electrode terminal 31 is coupled to the second high-side current path Lp2 extending from the second positive-electrode terminal 31 to a positive-electrode terminal 37a of the second power supply circuit 37, and is thus electrically coupled to the positive-electrode terminal 37a of the second power supply circuit 37. The second positive-electrode terminal 31 is configured to be detachably coupled to the first positive-electrode terminal 11 of the battery pack 1 connected to the charger 5.

The second negative-electrode terminal 32 is coupled to the second low-side current path Ln2 extending from the second negative-electrode terminal 32 to a negative-electrode terminal 37b of the second power supply circuit 37, and is thus electrically coupled to the negative-electrode terminal 37b of the second power supply circuit 37. The second negative-electrode terminal 32 is configured to be detachably coupled to the first negative-electrode terminal 12 of the battery pack 1 connected to the charger 5. Therefore, when the battery pack 1 is connected to the charger 5, the second low-side current path Ln2 is coupled to the ground of the battery pack 1, and the charger 5 and the battery pack 1 shares a common reference potential.

The second high-side current path Lp2 and the second low-side current path Ln2 are each configured to conduct the charge current Ichg. The second low-side current path Ln2 is also coupled to the second control circuit 36, the AC voltage measurement circuit 38, and the second temperature measurement circuit 39, and serves as a reference potential (or a reference voltage) for these circuits.

The second data communication terminal 33 is coupled to the second control circuit 36. The second data communication terminal 33 is also configured to be detachably coupled to the first data communication terminal 13 of the battery pack 1 connected to the charger 5. The second data communication terminal 33 is a terminal for serial communication between the second control circuit 36 and the first control circuit 18 in the battery pack 1 connected to the charger 5.

The Vcc output terminal 34 is configured to be supplied with the second power supply voltage Vcc from the second power supply circuit 37. The Vcc output terminal 34 is also configured to be detachably coupled to the Vcc input terminal 14 of the battery pack 1 connected to the charger 5.

The signal input terminal 35 is configured to be supplied with the second power supply voltage Vcc via the pull-up resistor R2. Furthermore, the signal input terminal 35 is configured to be detachably coupled to the notification signal output terminal 15 of the battery pack 1 connected to the charger 5. The signal input terminal 35 configured as above has a voltage equal to the second power supply voltage Vcc when (i) the charger 5 is not connected to the battery pack 1 and (ii) the signal input terminal 35 is open. Upon connection of the charger 5 to the battery pack 1, the voltage at the signal input terminal 35 drops below the second power supply voltage Vcc as a result of the signal input terminal 35 being electrically coupled to the notification signal generation circuit 23 of the battery pack 1 (i.e., the signal input terminal 35 is no longer in an open-circuit state).

The second control circuit 36 is configured to transmit and receive various signals between the second control circuit 36 and other various circuits and to perform various controls associated with charging of the battery pack 1. Specifically, the second control circuit 36 is a microcomputer including a CPU, a memory, I/O ports, a SCI, a DAC, and an ADC, but is not limited to such a microcomputer. In another embodiment, the second control circuit 36 may include an additional microcomputer. In yet another embodiment, the second control circuit 36 may include, in addition to or in place of the microcomputer, a logic circuit (or wired logic connection) including two or more electronic components. In yet another embodiment, the second control circuit 36 may include, in addition to or in place of the microcomputer, a GPU, an ASIC, an ASSP, and/or a PLD.

The signal input terminal 35 described above is also coupled to the second control circuit 36. The second control circuit 36 is configured (or programmed) (i) to detect that the charger 5 is not connected to the battery pack 1 in response to the signal input terminal 35 having a voltage equal to the second power supply voltage Vcc, and (ii) to detect that the charger 5 is connected to the battery pack 1 in response to the signal input terminal 35 having a voltage lower than the second power supply voltage Vcc.

The second power supply circuit 37 is a switched-mode power supply circuit (or a switched-mode AC-to-DC converter) configured to receive, from an external power source (not shown), AC power at 100 through 130 volts AC or 220 through 240 volts AC and to generate (i) the second power supply voltage Vcc, (ii) a charge voltage Vchg, and (iii) the charge current Ichg based on the received AC power. The second power supply voltage Vcc is supplied to (i) the Vcc output terminal 34 and (ii) the pull-up resistor R2, as described above. The charge voltage Vchg is applied between the second high-side current path Lp2 and the second low-side current path Ln2 via the positive-electrode terminal 37a and the negative-electrode terminal 37b of the second power supply circuit 37. The charge voltage Vchg is 18 volts DC, but is not limited thereto. In another embodiment, the charge voltage Vchg may be 40 volts DC, 14.4 volts DC, or 10.8 volts DC.

Additionally, the second power supply circuit 37 is configured to receive a PWM signal from the second control circuit 36 and to change the magnitude of the charge current Ichg in accordance with the received PWM signal. The second control circuit 36 is configured (or programmed) to change a duty cycle (or a duty ratio) of the PWM signal in accordance with the received notification signal.

The AC voltage measurement circuit 38 is configured to measure an AC voltage Vac supplied to the second power supply circuit 37 and to transmit an AC voltage measurement signal to the second control circuit 36. The AC voltage measurement signal is an analog signal having a variable voltage corresponding to a magnitude of the measured AC voltage Vac. The second control circuit 36 is configured (or programmed) to transmit, to the second power supply circuit 37, the PWM signal that reduces or stops the charge current Ichg, in response to the AC voltage measurement signal having a voltage outside its appropriate range. In another embodiment, the AC voltage measurement circuit 38 may be excluded from the charger 5. Such a circuit configuration, although less preferred, is encompassed within the scope of the present disclosure.

The second temperature measurement circuit 39 is configured to measure a temperature of the second power supply circuit 37 using a not-shown temperature sensing element (e.g., a thermistor) and to transmit a second temperature measurement signal to the second control circuit 36. The second temperature measurement signal is an analog signal having a variable voltage corresponding to the temperature of the second power supply circuit 37. The second control circuit 36 is configured (or programmed) to transmit, to the second power supply circuit 37, the PWM signal that reduces or stops the charge current Ichg in response to (i) the second temperature measurement signal having a voltage outside its appropriate range or (ii) the second temperature measurement signal having a voltage undergoing a rapid change. In another embodiment, the second temperature measurement circuit 39 may be excluded from the charger 5. Such a circuit configuration, although less preferred, is encompassed within the scope of the present disclosure.

The current measurement circuit 40 is disposed in the second low-side current path Ln2 such that the charge current Ichg passes through the current measurement circuit 40. The current measurement circuit 40 is configured (i) to measure the magnitude of the charge current Ichg and (ii) to transmit a charge current measurement signal Sch to the second control circuit 36. The charge current measurement signal Sch is an analog signal having a variable voltage corresponding to the magnitude of the charge current Ichg. The current measurement circuit 40 may include a shunt resistor (not shown) disposed in the second low-side current path Ln2.

The following details various processes executed by the first control circuit 18 of the battery pack 1.

### 2-1-3. State-Of-Charge Detection Process

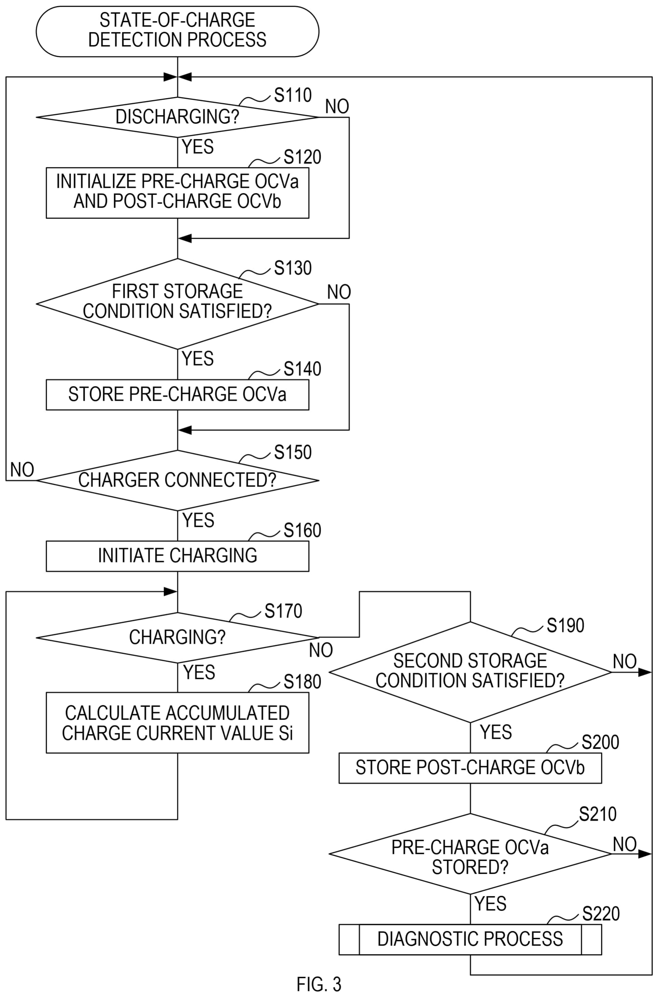

The first control circuit 18 repeatedly executes a state-of-charge detection process shown in FIG. 3 during its operation. The operation of the first control circuit 18 may, for example, be initiated when the first power supply voltage Vdd generated by the first power supply circuit 17 is supplied to the first control circuit 18. In other words, the battery pack 1 may be configured to initiate the state-of-charge detection process in response to activation of the first control circuit 18.

In the state-of-charge detection process, the first control circuit 18 first determines at S110 (S denotes a step) whether the assembled battery 16 is discharging. Specifically, the first control circuit 18 determines whether the assembled battery 16 is discharging based on the measured value of the discharge current Idis received from the measurement circuit 19. More specifically, the first control circuit 18 determines (i) that the assembled battery 16 is discharging if the measured value of the discharge current Idis exceeds a specified minimum value, and (ii) that the assembled battery 16 is not discharging if the measured value is less than or equal to the minimum value. In another embodiment, the first control circuit 18 may determine that the assembled battery 16 is discharging upon receipt, from job-site electrical equipment, of any signal indicating that the job-site electrical equipment is in operation (e.g., a signal indicating that a trigger switch is being operated).

If the assembled battery 16 is not discharging (S110: NO), the first control circuit 18 proceeds to S130. If the assembled battery 16 is discharging (S110: YES), the first control circuit 18 proceeds to S120.

At S120, the first control circuit 18 initializes first through nth pre-charge OCVa1 through OCVan (collectively referred to as pre-charge OCVa in FIG. 3) and first through nth post-charge OCVb1 through OCVbn (collectively referred to as post-charge OCVb in FIG. 3) to a null value (or zero). The first through nth pre-charge OCVa1 through OCVan are variables for storing the respective measured values of the first through nth module voltages Vmj1 through Vmjn when the first through nth battery modules 25a1 through 25an are open (i.e., when nothing is connected to the battery pack 1, or when some device is connected but no charge/discharge current is flowing) before a start of charging. The first through nth post-charge OCVb1 through OCVbn are variables for storing the respective measured values of the first through nth module voltages Vmj 1 through Vmjn when the first through nth battery modules 25a1 through 25an are open (i.e., when nothing is connected to the battery pack 1, or when some device is connected but no charge/discharge current is flowing) after an end of charging.

At subsequent S130, the first control circuit 18 determines whether a first storage condition is satisfied. The first storage condition is satisfied when (i) the assembled battery 16 is not discharging, and (ii) the first through nth module voltages Vmj1 through Vmjn are stabilized (i.e., the first through nth module voltages Vmj1 through Vmjn are not fluctuating).

If the first storage condition is not satisfied (S130: NO), the first control circuit 18 proceeds to S150. If the first storage condition is satisfied (S130: YES), the first control circuit 18 proceeds to S140 and stores the measured values of the first through nth module voltages Vmj1 through Vmjn in the first through nth pre-charge OCVa1 through OCVan, respectively.

At subsequent S150, the first control circuit 18 determines whether the charger 5 is connected to the battery pack 1. If the charger 5 is not connected to the battery pack 1 (S150: NO), the first control circuit 18 returns to S110.

If the charger 5 is connected to the battery pack 1 (S150: YES), the first control circuit 18 proceeds to S160 and initiates charging of the battery pack 1 (specifically, the assembled battery 16) by the charger 5. Specifically, the first control circuit 18 outputs, to the notification signal generation circuit 23, the current control signal corresponding to the requested value of the charge current Ichg greater than zero amperes. In response to such a current control signal, the notification signal corresponding to the current control signal is output from the notification signal generation circuit 23 to the second control circuit 36 of the charger 5, and charging of the battery pack 1 is initiated. Additionally, the first control circuit 18 initializes an accumulated charge current value Si to zero. The accumulated charge current value Si is a variable indicating a sum of the charge current Ichg flowing into the assembled battery 16.

At subsequent S170, the first control circuit 18 determines whether the assembled battery 16 is being charged. Specifically, the first control circuit 18 determines whether the assembled battery 16 is being charged based on the current control signal (more specifically, its duty cycle) being supplied to the notification signal generation circuit 23. In another embodiment, the first control circuit 18 may determine whether the assembled battery 16 is being charged based on the measured value of the charge current Ichg received from the measurement circuit 19.

If the assembled battery 16 is being charged (S170: YES), the first control circuit 18 proceeds to S180, adds the measured value of the charge current Ich received from the measurement circuit 19 to the accumulated charge current value Si, and returns to S170.

If the assembled battery 16 is not being charged (S170: NO), the first control circuit 18 proceeds to S190 to determine whether a second storage condition is satisfied. The second storage condition is satisfied when (i) the assembled battery 16 is not discharging, and (ii) the respective measured values of the first through nth module voltages Vmj 1 through Vmjn are not fluctuating.

If the second storage condition is not satisfied (S190: NO), the first control circuit 18 returns to S110.

If the second storage condition is satisfied (S190: YES), the first control circuit 18 proceeds to S200 to store the measured values of the first through nth module voltages Vmj1 through Vmjn in the first through nth post-charge OCVb1 through OCVbn, respectively.

At subsequent S210, the first control circuit 18 determines whether the first through nth pre-charge OCVa1 through OCVan are stored. Specifically, the first control circuit 18 determines whether the first through nth pre-charge OCVa1 through OCVan are null values (or zero). The first control circuit 18 determines that the first through nth pre-charge OCVa1 through OCVan are not stored if the first through nth pre-charge OCVa1 through OCVan are null values (or zero). If the first through nth pre-charge OCVa1 through OCVan are not null values (or zero), the first control circuit 18 determines that the first through nth pre-charge OCVa1 through OCVan are stored.

The first control circuit 18 (i) returns to S110 if the first through nth pre-charge OCVa1 through OCVan are not stored (S210: NO), and (ii) proceeds to S220 to execute a diagnostic process if the first through nth pre-charge OCVa1 through OCVan are stored (S210: YES).

### 2-1-4. Diagnostic Process

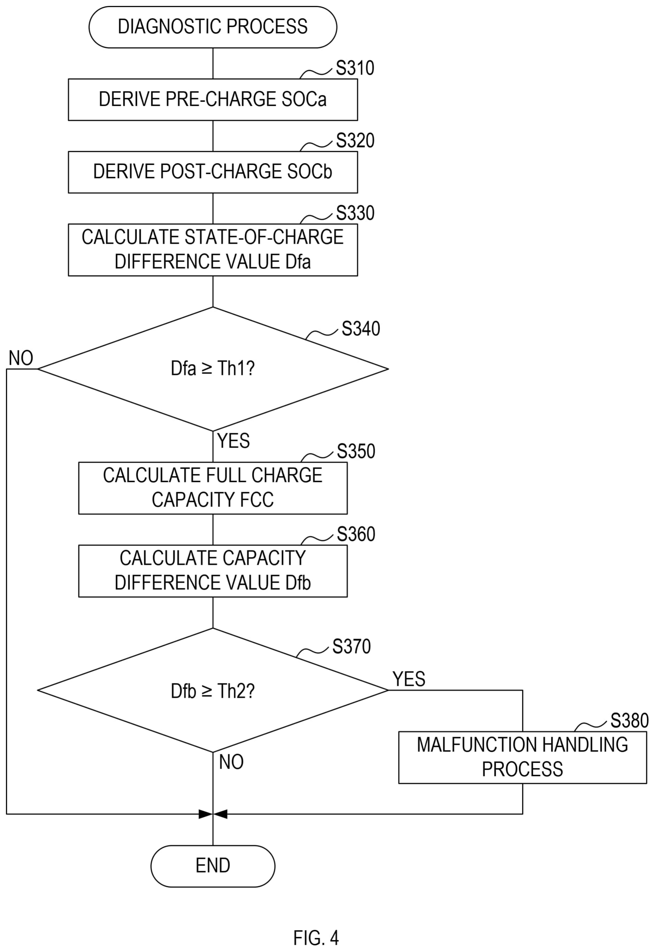

In the diagnostic process, the first control circuit 18 derives first through nth pre-charge SOCa1 through SOCan (collectively referred to as pre-charge SOCa in FIG. 4) at S310. The first through nth pre-charge SOCa1 through SOCan are variables for storing respective pre-charge states of charge of the first through nth battery modules 25a1 through 25an.

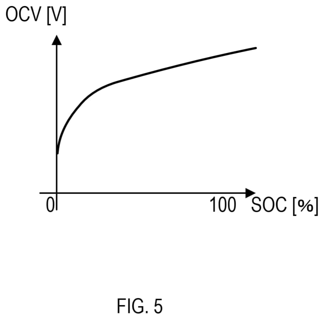

Specifically, the first control circuit 18 derives the first through nth pre-charge SOCa1 through SOCan based on a lookup table preset in the first control circuit 18. The lookup table associates open circuit voltages (OCV) of the first through nth battery modules 25a1 through 25an with their respective states of charge based on characteristics of open circuit voltage relative to state of charge (SOC) as shown in FIG. 5. Accordingly, the first control circuit 18 (i) obtains, from the lookup table, the respective states of charge corresponding to the first through nth pre-charge OCVa1 through OCVan, and (ii) stores the obtained states of charge into the first through nth pre-charge SOCa1 through SOCan, respectively. In another embodiment, the first control circuit 18 may (i) calculate the respective states of charge corresponding to the first through nth pre-charge OCVa1 through OCVan based on a mathematical function representing the characteristics shown in FIG. 5, and (ii) store the calculated states of charge into the first through nth pre-charge SOCa1 through SOCan, respectively.

At subsequent S320, the first control circuit 18 derives first through nth post-charge SOCb1 through SOCbn (collectively referred to as post-charge SOCb in FIG. 4). The first through nth post-charge SOCb1 through SOCbn are variables for storing respective post-charge states of charge of the first through nth battery modules 25al through 25an.

Specifically, as at S310, the first control circuit 18 (i) obtains, from the lookup table, the respective states of charge corresponding to the first through nth post-charge OCVb1 through OCVbn, and (ii) stores the obtained respective states of charge into the first through nth post-charge SOCb1 through SOCbn. In another embodiment, the first control circuit 18 may (i) calculate the respective states of charge corresponding to the first through nth post-charge OCVb1 through OCVbn based on the mathematical function representing the characteristics shown in FIG. 5, and (ii) store the calculated respective states of charge into the first through nth post-charge SOCb1 through SOCbn.

At subsequent S330, the first control circuit 18 calculates first through nth state-of-charge difference values Dfal through Dfan (collectively referred to as state-of-charge difference value Dfa in FIG. 4). Each of the first through nth state-of-charge difference values Dfal through Dfan corresponds to a difference between one of the first through nth pre-charge SOCa1 through SOCan and the corresponding one of the first through nth post-charge SOCb1 through SOCbn. In another embodiment, the first control circuit 18 may calculate any one of the first through nth state-of-charge difference values Dfal through Dfan.

At subsequent S340, the first control circuit 18 determines whether all the first through nth state-of-charge difference values Dfal through Dfan are greater than or equal to a preset first threshold Th1. The first threshold Th1 is any threshold for determining whether the respective states of charge of the first through nth battery modules 25a1 through 25an has increased sufficiently to detect a malfunction in the first through nth battery modules 25a1 through 25an. The first threshold Th1 may be set to a specified percentage. Specifically, the first threshold Th1 may be 25%, 50%, or 75%.

If any of the first through nth state-of-charge difference values Dfa1 through Dfan is less than the first threshold Th1 (S340: NO), the first control circuit 18 immediately terminates the diagnostic process.

If all the first through nth state-of-charge difference values Dfal through Dfan are greater than or equal to the first threshold Th1 (S340: YES), the first control circuit 18 proceeds to S350.

At S350, the first control circuit 18 calculates respective first through nth full charge capacities FCC1 through FCCn (collectively referred to as the full charge capacity FCC in FIG. 4) of the first through nth battery modules 25al through 25an. Specifically, the first control circuit 18 calculates the first through nth full charge capacities FCC1 through FCCn based on the accumulated charge current value Si, the first through nth pre-charge SOCa1 through SOCan, the first through nth post-charge SOCb1 through SOCbn, and the following Equation 1.
Equation 1: 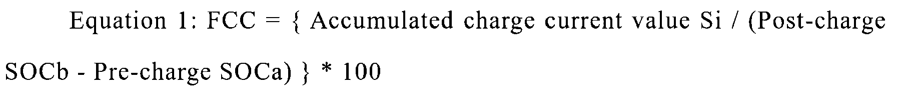 FCC = { Accumulated charge current value Si / (Post-charge SOCb - Pre-charge SOCa) } * 100

At subsequent S360, the first control circuit 18 calculates a capacity difference value Dfb. The capacity difference value Dfb corresponds to a difference between the maximum and minimum values of the first through nth full charge capacities FCC1 through FCCn.

At subsequent S370, the first control circuit 18 determines whether the capacity difference value Dfb is greater than or equal to a preset second threshold Th2. The second threshold Th2 is set based on a difference between a full charge capacity of a non-malfunctioning battery module and a full charge capacity of a malfunctioning battery module.

If the capacity difference value Dfb is less than the second threshold Th2 (S370: NO), the first control circuit 18 terminates the diagnostic process. If the capacity difference value Dfb is greater than or equal to the second threshold Th2 (S370: YES), the first control circuit 18 proceeds to S380 to execute a malfunction handling process (S380).

In the malfunction handling process, the first control circuit 18 may increment a malfunction detection count in any of the first through nth battery modules 25a1 through 25an. Upon the malfunction detection count reaching a specified count, the first control circuit 18 may execute a process for disabling the battery pack 1. More specifically, the first control circuit 18 may transmit a prohibition signal for prohibiting charging and discharging of the battery pack 1. The prohibition signal can disable charging by the charger 5 connected to the battery pack 1 or discharging to the job-site electrical equipment connected to the battery pack 1.

Alternatively, the first control circuit 18 may store data for identifying the battery module having the minimum full charge capacity. In this case, the malfunctioning battery module can be identified at a later time.

### 2-1-5. Effects in First Embodiment

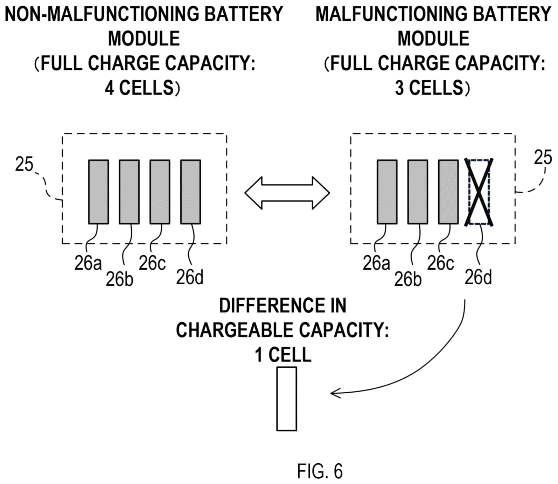

Effects in the first embodiment are described with reference to FIG. 6.

In FIG. 6, the full charge capacity of a non-malfunctioning battery module 25 is the sum of the full charge capacities of the first through fourth cells 26a through 26d. In contrast, in a malfunctioning battery module 25, one of the first through fourth cells 26a through 26d (the fourth cell 26d) is electrically uncoupled from the remaining cells (the first through third cells 26a through 26c). In this case, the full charge capacity of the malfunctioning battery module 25 is the sum of the charge capacities of the first through third cells 26a through 26c.

Therefore, a difference equivalent to the full charge capacity of the fourth cell 26d arises between the full charge capacity of the non-malfunctioning battery module 25 and the full charge capacity of the malfunctioning battery module 25.

In other words, the full charge capacity of the battery module 25 is proportional to the number of non-malfunctioning cells 26. Consequently, if a malfunction occurs in at least one of the first through fourth cells 26a through 26d, the full charge capacity of the battery module 25 decreases in proportion to the number of malfunctioning cells 26 compared to a state in which all first through fourth cells 26a through 26d are non-malfunctioning.

Accordingly, for example, by setting the second threshold Th2 to 90% of the full charge capacity of the cells 26, it enables a detection of a malfunction in at least one of the first through nth battery modules 25a1 through 25an.

Therefore, performing cell balancing among the first through nth battery modules 25a1 through 25an by the measurement circuit 19 can avoid overcharging of the malfunctioning battery module, thereby inhibiting a malfunction from occurring in the battery pack 1.

Examples of the above malfunction include any of the first through fourth cells 26a through 26d being electrically uncoupled from the remaining cells. More specifically, examples of the malfunction include, but are not limited to, a spot weld coming loose, and an internal current collector of any of the first through fourth cells 26a through 26d being uncoupled from its positive-electrode terminal or its negative-electrode terminal.

### 2-1-6. Correspondence between Terms

In the first embodiment, the capacity difference value Dfb corresponds to a non-limiting example of the difference value in Overview of Embodiments, and the second threshold Th2 corresponds to a non-limiting example of the first threshold in Overview of Embodiments.

### 2-2. Second Embodiment

The second embodiment corresponds to a partially modified first embodiment. More specifically, the second embodiment differs from the first embodiment in that the first control circuit 18 receives the measured value of the charge current Ichg not from the measurement circuit 19 but from the charger 5. Therefore, the following description focuses only on portions differing from the first embodiment.

In the second embodiment, the second control circuit 36 is configured to transmit the magnitude of the charge current Ichg detected by the current measurement circuit 40 to the battery pack 1 (specifically, the first control circuit 18) via serial communication through the first data communication terminal 13 and the second data communication terminal 33.

In another embodiment, the second control circuit 36 may be configured to transmit, to the first control circuit 18 as the magnitude of the charge current Ichg, (i) the duty cycle of the PWM signal transmitted from the second control circuit 36 to the second power supply circuit 37, or (ii) a parameter associated with the duty cycle. In this case, the second control circuit 36 can transmit the magnitude of the charge current Ichg to the first control circuit 18 without the current measurement circuit 40 detecting the magnitude of the charge current Ichg.

The first control circuit 18 is configured to determine, at S170, whether the assembled battery 16 is being charged based on the magnitude of the charge current Ichg received from the second control circuit 36. Additionally, the first control circuit 18 is configured to add the magnitude of the charge current Ichg received from the second control circuit 36 to the accumulated charge current value Si at S180.

In the battery pack 1 configured as above, a malfunction of the battery module 25 can be detected based on the magnitude of the charge current Ichg received from the charger 5.

### 2-3. Third Embodiment

The third embodiment corresponds to a partially modified first embodiment. More specifically, the diagnostic process in the third embodiment partially differs from that in the first embodiment. Therefore, the following description focuses only on portions differing from the first embodiment.

The diagnostic process of the third embodiment differs from that of the first embodiment in that a malfunction of the battery module 25 is detected based on a capacity ratio Rfa. The capacity ratio Rfa is a ratio of the minimum value to the maximum value among the first through nth full charge capacities FCC1 through FCCn (i.e., Rfa = FCC min / FCC max).

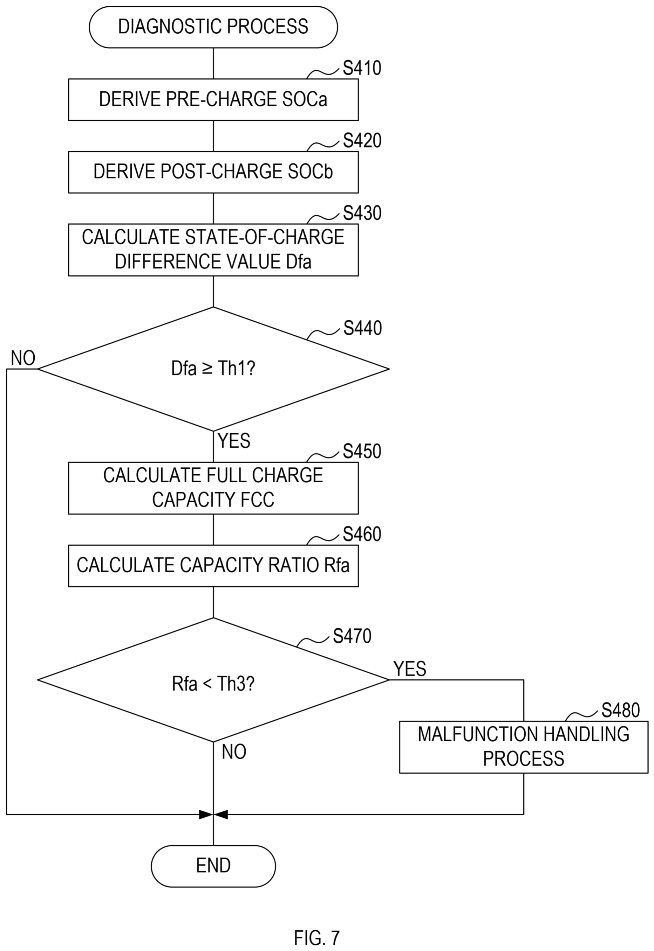

As shown in FIG. 7, processes at S410 through S450 and S480 in the diagnostic process of the third embodiment are the same as the processes at S310 through S350 and S380 in the first embodiment.

In the third embodiment, at S460, the first control circuit 18 calculates the capacity ratio Rfa.

At subsequent S470, the first control circuit 18 determines whether the capacity ratio Rfa is less than a preset third threshold Th3. The third threshold Th3 is set based on a ratio of a full charge capacity FCC (hereinafter referred to as malfunctioning capacity FCCb) of a malfunctioning battery module to a full charge capacity FCC (hereinafter referred to as non-malfunctioning capacity FCCa) of a non-malfunctioning battery module.

If the capacity ratio Rfa is greater than or equal to the third threshold Th3 (S470: NO), the first control circuit 18 terminates the diagnostic process. If the capacity ratio Rfa is less than the third threshold Th3 (S470: YES), the first control circuit 18 proceeds to S480 to execute the malfunction handling process.

The third threshold Th3 may be set to a specified value for determining a malfunctioning battery module based on the above ratio (i.e., malfunctioning capacity FCCb / non-malfunctioning capacity FCCa).

For example, if one of the first through fourth cells 26a through 26d is electrically uncoupled from the remaining cells, the ratio (= malfunctioning capacity FCCb / non-malfunctioning capacity FCCa) becomes 3/4, that is, 0.75. If two cells are electrically uncoupled from the remaining cells, the ratio becomes 2/4, that is, 0.5. Therefore, by setting the third threshold Th3 to 0.76 and comparing the capacity ratio Rfa with the third threshold Th3, it may be determined whether there is any malfunctioning battery module within the first through nth battery modules 25a1 through 25an. In other words, the first control circuit 18 may determine, when the capacity ratio Rfa falls below the third threshold Th3, that a malfunction is occurring in the battery module with the smallest full charge capacity among the first through nth battery modules 25a1 through 25an.

As described above, the battery pack 1 of the third embodiment can detect that a malfunction is occurring in at least one of the first through nth battery modules 25a1 through 25an.

In the third embodiment, as in the first embodiment, performing cell balancing among the first through nth battery modules 25a1 through 25an by the measurement circuit 19 can inhibit overcharging of the malfunctioning battery module, and thereby can reduce damage to the battery pack 1.

The capacity ratio Rfa corresponds to a non-limiting example of the ratio in Overview of Embodiments, and the third threshold Th3 corresponds to a non-limiting example of the second threshold in Overview of Embodiments.

### 2-4. Further Embodiments

The embodiments of the present disclosure have been described above. However, the present disclosure is not limited to the embodiments described above and may be implemented in various modifications.

In one of further embodiments, the first control circuit 18 may calculate respective deviations of the first through nth full charge capacities FCC1 through FCCn (hereinafter referred to as the first through nth capacity deviations DVC1 through DVCn), and may detect that a malfunction is occurring in at least any one of the first through nth battery modules 25a1 through 25an based on the first through nth capacity deviations DVC1 through DVCn.

Specifically, the first control circuit 18 may calculate the first through nth capacity deviations DVC1 through DVCn at S360 of the first embodiment. More specifically, the first control circuit 18 may calculate an average value of the first through nth full charge capacities FCC1 through FCCn (hereinafter referred to as the capacity average value Avc). Additionally, the first control circuit 18 may calculate the first through nth capacity deviations DVC1 through DVCn by subtracting the capacity average value Avc from the first through nth full charge capacities FCC1 through FCCn, respectively (i.e., full charge capacity FCC - capacity average value Avc).

At subsequent S370, the first control circuit 18 may determine whether any of the first through nth battery modules 25a1 through 25an is malfunctioning based on the first through nth capacity deviations DVC1 through DVCn. More specifically, the first control circuit 18 may determine whether each of the first through nth capacity deviations DVC1 through DVCn is less than a preset fourth threshold Th4.

The fourth threshold Th4 may be set to any numerical value between a capacity deviation DVC of a non-malfunctioning battery module (hereinafter referred to as non-malfunctioning capacity deviation DVCc) and a capacity deviation DVC of a malfunctioning battery module (hereinafter referred to as malfunctioning capacity deviation DVCd). For example, the fourth threshold Th4 may be set to an intermediate value between the non-malfunctioning capacity deviation DVCc and the malfunctioning capacity deviation DVCd (i.e., (non-malfunctioning capacity deviation DVCc - malfunctioning capacity deviation DVCd) / 2 + malfunctioning capacity deviation DVCd). In other words, the fourth threshold Th4 may be set to a numerical value for determining a malfunctioning battery module based on the non-malfunctioning capacity deviation DVCc and the malfunctioning capacity deviation DVCd.

In another one of further embodiments, the first control circuit 18 may determine whether any of the first through nth battery modules 25a1 through 25an is malfunctioning based on a specified reference value LV, when the assembled battery 16 is charged to its full charge capacity without interruption during charging.

For example, in the diagnostic process in the first embodiment, S330 may be omitted, and the first control circuit 18 may determine, at S340, whether the post-charge SOCb is greater than or equal to a fifth threshold Th5. In this case, the fifth threshold Th5 may be set to a value equivalent to 100% of the rated capacity of each of the first through nth battery modules 25a1 through 25an. If the assembled battery 16 is fully charged and the post-charge SOCb is greater than or equal to the fifth threshold Th5 (S340: YES), the first control circuit 18 may proceed to S350. If the assembled battery 16 is not fully charged and the post-charge SOCb is less than the fifth threshold Th5 (S340: NO), the first control circuit 18 may immediately terminate the diagnostic process.

At S360, the first control circuit 18 may identify the battery module having the minimum value (hereinafter referred to as FCC minimum value) among the first through nth full charge capacities FCC1 through FCCn.

At S370, the first control circuit 18 may compare the FCC minimum value with the reference value LV to determine whether any of the first through nth battery modules 25al through 25an is malfunctioning. Specifically, the first control circuit 18 may determine whether the FCC minimum value is less than the reference value LV (i.e., FCC minimum value < reference value LV). If the FCC minimum value is less than the reference value LV, that is, a malfunctioning battery module exists (S370: YES), the first control circuit 18 may proceed to S380. If the FCC minimum value is greater than or equal to the reference value LV, that is, no malfunctioning battery module exists (S370: NO), the first control circuit 18 may immediately terminate the diagnostic process.

The reference value LV may be set to a numerical value determined with reference to the rated capacity of each of the first through nth battery modules 25al through 25an. Specifically, the reference value LV may be set to a value equivalent to 80% of the rated capacity of each of the first through nth battery modules 25a1 through 25an.

### 2-5. General Interpretation

Two or more functions achieved by a single component in the above embodiments may be achieved by two or more components, and a single function achieved by a single component may be achieved by two or more components. In addition, two or more functions achieved by two or more components may be achieved by a single component, and a single function achieved by two or more components may be achieved by a single component. Further, a part of the configuration of the above embodiments may be omitted. Moreover, at least a part of the configuration of one of the above embodiments may be added to or replaced with another configuration of the above embodiments.

## Claims

1. A battery pack (1) for job-site electrical equipment, the battery pack comprising:
a first positive-electrode terminal (11) and a first negative-electrode terminal (12) configured to receive charge power from a charger (5);
first through nth battery modules (25a1-25an) (i) coupled in series in order and (ii) configured to be charged by the charge power, wherein each of the first through nth battery modules includes two or more rechargeable battery cells (26a-26d) coupled in parallel, the first battery module (25a1) includes a second positive-electrode terminal (25a1a) coupled to the first positive-electrode terminal, and the nth battery module (25an) includes a second negative-electrode terminal (25anb) coupled to the first negative-electrode terminal, and n is any natural number greater than or equal to two; and
a control circuit (18) configured (i) to derive respective full charge capacities of the first through nth battery modules based on measured values associated with respective states of charge of the first through nth battery modules, and (ii) to detect a malfunction in at least any one of the first through nth battery modules based on the respective full charge capacities derived.

2. The battery pack according to claim 1, further comprising
a measurement circuit (19) configured (i) to measure respective voltage values of the first through nth battery modules and (ii) to transmit the respective voltage values,
wherein the control circuit is configured to receive the respective voltage values from the measurement circuit as part of the measured values.

3. The battery pack according to claim 2, wherein:
the measurement circuit is configured (i) to measure an electric current value corresponding to a magnitude of a charge current supplied from the charger to the battery pack and (ii) to transmit the electric current value; and
the control circuit is configured to receive the electric current value from the measurement circuit as part of the measured values.

4. The battery pack according to claim 2, wherein:
the charger is configured to transmit an electric current value corresponding to a magnitude of a charge current supplied from the charger to the battery pack; and
the control circuit is configured to receive the electric current value from the charger as part of the measured values.

5. The battery pack according to claim 3 or 4, wherein:
the control circuit is configured:
to derive an accumulated value of the electric current value from a start of charging to an end of charging of the battery pack;
to derive respective pre-charge states of charge and respective post-charge states of charge of the first through nth battery modules based on respective pre-charge voltage values and respective post-charge voltage values of the first through nth battery modules; and
to derive the respective full charge capacities based on the accumulated value, the respective pre-charge states of charge, and the respective post-charge states of charge;
the respective pre-charge voltage values correspond to the respective voltage values of the first through nth battery modules before the start of charging;
the respective post-charge voltage values correspond to the respective voltage values of the first through nth battery modules after the end of charging;
the respective pre-charge states of charge correspond to respective states of charge of the first through nth battery modules before the start of charging; and
the respective post-charge states of charge correspond to respective states of charge of the first through nth battery modules after the end of charging.

6. The battery pack according to claim 5, wherein:
the respective pre-charge voltage values correspond to respective open circuit voltages of the first through nth battery modules before the start of charging; and
the respective post-charge voltage values correspond to respective open circuit voltages of the first through nth battery modules after the end of charging.

7. The battery pack according to claim 5, wherein:
the respective pre-charge voltage values correspond to respective stabilized open circuit voltages of the first through nth battery modules before the start of charging; and
the respective post-charge voltage values correspond to respective stabilized open circuit voltages of the first through nth battery modules after the end of charging.

8. The battery pack according to any one of claims 1 through 7,
wherein the control circuit is configured to detect the malfunction based on (i) a difference value between a largest full charge capacity and a smallest full charge capacity among the respective full charge capacities, and (ii) a preset first threshold.

9. The battery pack according to any one of claims 1 through 8,
wherein the control circuit is configured to detect the malfunction based on (i) a ratio of a smallest full charge capacity to a largest full charge capacity among the respective full charge capacities, and (ii) a preset second threshold.

10. The battery pack according to any one of claims 1 through 9,
wherein the malfunction includes at least one rechargeable battery cell being electrically uncoupled from remaining rechargeable battery cells among the two or more rechargeable battery cells in at least any one of the first through nth battery modules.

11. The battery pack according to any one of claims 1 through 10,
wherein each of the first through nth battery modules has an identical rated capacity or an identical nominal capacity.

12. The battery pack according to any one of claims 1 through 11,
wherein the control circuit is configured, in response to detection of the malfunction in at least any one of the first through nth battery modules, (i) to transmit a prohibition signal for prohibiting charging and discharging of the battery pack and/or (ii) to store data identifying a malfunctioning battery module (26d).

13. A method for diagnosing a battery pack (1) for job-site electrical equipment, the method comprising:
deriving respective full charge capacities of two or more battery modules (25a1-25an) of the battery pack based on respective states of charge of the two or more battery modules, the two or more battery modules being coupled in series, each of the two or more battery modules including two or more rechargeable battery cells (26a-26d) coupled in parallel; and
detecting a malfunction in at least any one of the two or more battery modules based on the respective full charge capacities derived.
